# EUROPEAN PATENT APPLICATION

(11) **EP 4 528 424 A1**
(43) Date of publication of application: **26.03.2025**
(21) Application number: 24200330.9
(22) Date of filing: 13.09.2024
(51) Int. Cl.: G06F 1/16, G09F 9/30

(54) **DISPLAY PANEL**

(30) Priority: 22.09.2023 KR 20230127107
(71) Applicant: Samsung Display Co., Ltd., Gyeonggi-do 17113 (KR)
(72) Inventor: CHOI, Ji Woong, 17113 Yongin-si (KR)
(74) Representative: Walaski, Jan Filip

(57) **Abstract**

Disclosed is a display panel including a substrate including a first portion having a first thickness and a second portion adjacent to the first portion in a first direction. The second portion has a second thickness smaller than the first thickness. The display panel includes a circuit layer disposed on the substrate and an element layer disposed on the circuit layer. A plurality of slit grooves extending along a second direction crossing the first direction and recessed in a thickness direction of the substrate are defined on a bottom surface of the first portion of the substrate.

## Description

This application claims priority to Korean Patent Application No. 10-2023-0127107, filed on 22 September 2023.

### BACKGROUND

The present disclosure relates to a rollable display panel and an electronic device including the same.

Flexible display panels are being developed according to market demands. Some flexible display panels include curved display panels that are fixed with a specific curvature, foldable display panels that may be bent at a specific radius of curvature or more or around a folding axis, and rollable display panels that may be rolled at a specific radius of curvature. Electronic devices, to which, among them, rollable display panels are applied, may have a small volume but provide a large display area.

### SUMMARY

Embodiments of the present disclosure provide a rollable display panel.

Embodiments of the present disclosure also provide an electronic device including a rollable display panel.

According to an embodiment, a display panel includes a substrate including a first portion having a first thickness, and a second portion adjacent to the first portion in a first direction and having a second thickness smaller than the first thickness, a circuit layer disposed on the substrate, and an element layer disposed on the circuit layer, and a plurality of slit grooves extending along a second direction crossing the first direction and recessed in a thickness direction of the substrate are defined on a bottom surface of the first portion of the substrate.

A width of the substrate in the second direction may be substantially equal to lengths of the plurality of slit grooves in the second direction.

A depth of each of the plurality of slit grooves may be substantially equal to a difference between the first thickness and the second thickness.

A depth of each of the plurality of slit grooves may be greater than a difference between the first thickness and the second thickness.

A depth of each of the plurality of slit grooves may be smaller than a difference between the first thickness and the second thickness.

The first thickness may be five times or greater than the second thickness.

Each of the plurality of slit grooves may have a shape recessed from a lower surface of the substrate toward an upper surface of the substrate, and the upper surface of the substrate may continuously extend across the first portion and the second portion to define a same plane.

The lower surface of the substrate may include a first lower surface overlapping the first portion and a second lower surface overlapping the second portion, and a boundary surface connecting the first lower surface and the second lower surface is a flat surface, the first lower surface is the bottom surface of the first portion.

The lower surface of the substrate may include a first lower surface overlapping the first portion and a second lower surface overlapping the second portion, and a boundary surface connecting the first lower surface and the second lower surface includes a curved surface, the first lower surface is the bottom surface of the first portion.

The display panel may further include a plurality of filling members disposed in the plurality of slit grooves, respectively.

Each of the plurality of slit grooves may have a shape that is recessed from a lower surface of the substrate toward an upper surface of the substrate, and each of the plurality of filling members may be aligned with the lower surface of the substrate.

Each of the plurality of slit grooves may have a shape recessed from a lower surface of the substrate toward an upper surface of the substrate, and each of the plurality of filling members may be aligned with the lower surface of the substrate and have a shape recessed concavely from the lower surface of the substrate.

Each of the plurality of slit grooves may have a shape recessed from a lower surface of the substrate toward an upper surface of the substrate, and each of the plurality of filling members may have a shape protruding convexly from the lower surface of the substrate.

The display panel may further include a cover layer provided integrally with the plurality of filling members, and covering the bottom surface of the first portion of the substrate.

A shape of each of the plurality of slit grooves on a cross-section may be defined by a first line, a straight line connected to the first line, and a second line connected to the straight line.

A shape of each of the plurality of slit grooves on a cross-section may be defined by a first line, a curved line connected to the first line, and a second line connected to the curved line.

The substrate may be a glass substrate, and the first portion and the second portion of the substrate may be flexible.

According to an embodiment, an electronic device includes a housing, in which a slot is defined, a rotation part disposed in the housing, and a display panel coupled to the rotation part, the display panel including a substrate including a first portion having a first thickness and a second portion adjacent to the first portion in the first direction and having a second thickness, a circuit layer disposed on the substrate, and an element layer disposed on the circuit layer, and a plurality of slit grooves extending along a second direction crossing the first direction and recessed in a thickness direction of the substrate are defined on a bottom surface of the first portion of the substrate.

The display panel may further include a first surface, on which an image is displayed, and a second surface opposed to the first surface, and a portion of the first surface of the display panel is coupled to the rotation part.

The display panel may further include a first surface, on which an image is displayed, and a second surface opposed to the first surface, and a portion of the second surface of the display panel is coupled to the rotation part.

The electronic device may further include a connection film electrically connected to the display panel and attached to an area overlapping the first portion, and a circuit substrate electrically connected to the connection film and seated on the rotation part.

The electronic device may further include a seating space defined in the rotation part and recessed from an outer peripheral surface, on which the display panel is wound, wherein the circuit substrate is disposed in the seating space.

The electronic device may further include a circuit substrate fixing part disposed in a space defined in the rotation part, wherein the circuit substrate is fixed to the circuit substrate fixing part, and the circuit substrate fixing part is fixed to the rotation part.

The display panel may further include a plurality of filling members disposed in the plurality of slit grooves, respectively.

According to an embodiment, a display panel includes a substrate including a first portion, and a second portion adjacent to the first portion in a first direction, a circuit layer disposed on the substrate, and an element layer disposed on the circuit layer, and overlapping the second portion, and the first portion includes a plurality of first sub portions having a first thickness, and a plurality of second sub portions having a second thickness smaller than the first thickness, wherein the plurality of first sub portions and the plurality of second sub portions are repeatedly alternately arranged one by one in the first direction.

A thickness of the second portion may be smaller than the first thickness.

The thickness of the second portion may be larger than the second thickness, or may be smaller than the second thickness.

The display panel may further include a filling member disposed between two adjacent first sub portions of the plurality of first sub portions.

### BRIEF DESCRIPTION OF THE FIGURES

The above and other objects and features of the present disclosure will become apparent by describing in detail embodiments thereof with reference to the accompanying drawings.
FIG. 1A is a perspective view of an electronic device.
FIG. 1B is a perspective view of an electronic device.
FIG. 2 is a plan view of a display device.
FIG. 3 is a cross-sectional view of a display panel.
FIG. 4A is a cross-sectional view of an electronic device.
FIG. 4B is a cross-sectional view of an electronic device.
FIG. 5A is a cross-sectional view of an electronic device.
FIG. 5B is a cross-sectional view of an electronic device.
FIGS. 6A to 6C are views illustrating a part of a process of manufacturing a display panel.
FIG. 7 is a cross-sectional view of a display device.
FIG. 8A is a cross-sectional view of a display device.
FIG. 8B is a cross-sectional view of a display device.
FIG. 8C is a cross-sectional view of a display device.
FIG. 9 is a cross-sectional view of a display device.
FIG. 10A is a cross-sectional view of a display device.
FIG. 10B is a cross-sectional view of a display device.

### DETAILED DESCRIPTION

In the specification, when it is described that a component (or an area, a layer, a part, or the like) is "disposed on", "connected to", or "coupled to" another component, it means that the former component may be directly disposed on, connected to, or coupled to the latter component or a third component may be disposed between the components.

The same reference numerals refer to the same elements. Furthermore, in the drawings, the thicknesses, proportions, and dimensions of the components are exaggerated for effective description of the technical contents. "And/or" includes all combinations of one or more that may be defined by the associated components.

Although the terms "first", "second", and the like may be used to describe various components, the components should not be limited by the terms. These terms are merely used to distinguish one component from other components. For example, a first component may be referred to as a second component without departing from the scope of the present disclosure, and similarly, the second component may also be referred to as the first component. Singular expressions include plural expressions unless the context clearly dictates otherwise.

Furthermore, the terms, such as, for example, "below," "on a lower side," "above," and "on an upper side" are used to describe the relationships between the components illustrated in the drawings. The above terms are relative concepts and are described based on directions that are indicated in the drawings.

It should be understood that the terms, such as, for example, "include" or "have", are intended to designate the presence of features, numbers, steps, operations, components, parts, or combinations thereof, which are described in the specification, but do not exclude a possibility of adding one or more other features, numbers, steps, operations, components, parts, or combinations thereof.

The term "substantially," as used herein, means approximately or actually. The term "substantially equal" means approximately or actually equal. The term "substantially the same" means approximately or actually the same.

Embodiments of the present disclosure support one or more processes (or methods) supportive of the features and embodiments described herein. Descriptions that an element "may be disposed," "may be formed," "may be etched," and the like include processes (or methods) and techniques for disposing, forming, etching, positioning, and modifying the element, and the like in accordance with example aspects described herein.

Unless otherwise defined, all terms (including technical terms and scientific terms) used in this specification have the same meanings as commonly understood by an ordinary person skilled in the art, to which the present disclosure pertains. Furthermore, the terms, such as those defined in commonly used dictionaries, should be interpreted as having meanings that agree with the meanings the terms have in the context of the relevant technology, and unless explicitly defined herein, should not be interpreted as having overly idealistic or overly formal meanings.

Hereinafter, embodiments will be described with reference to the drawings.

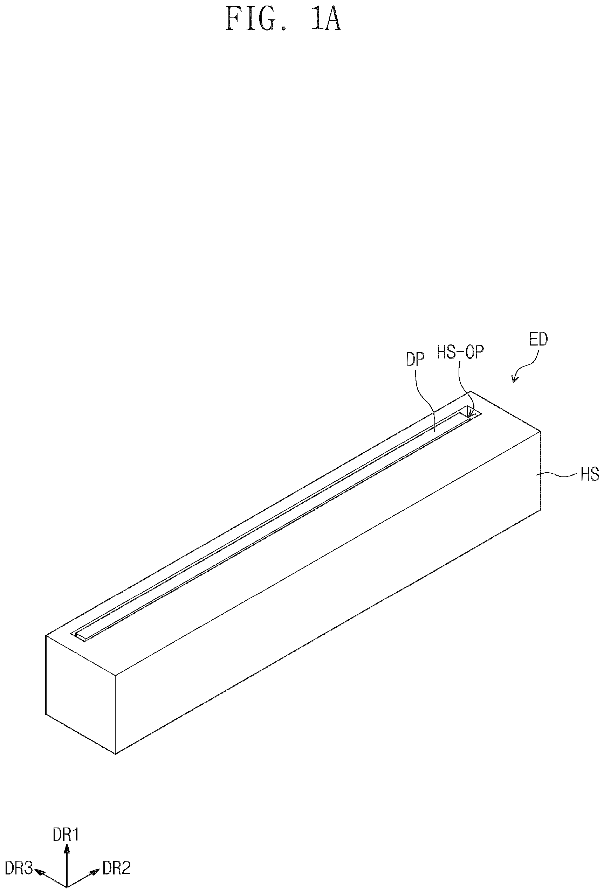

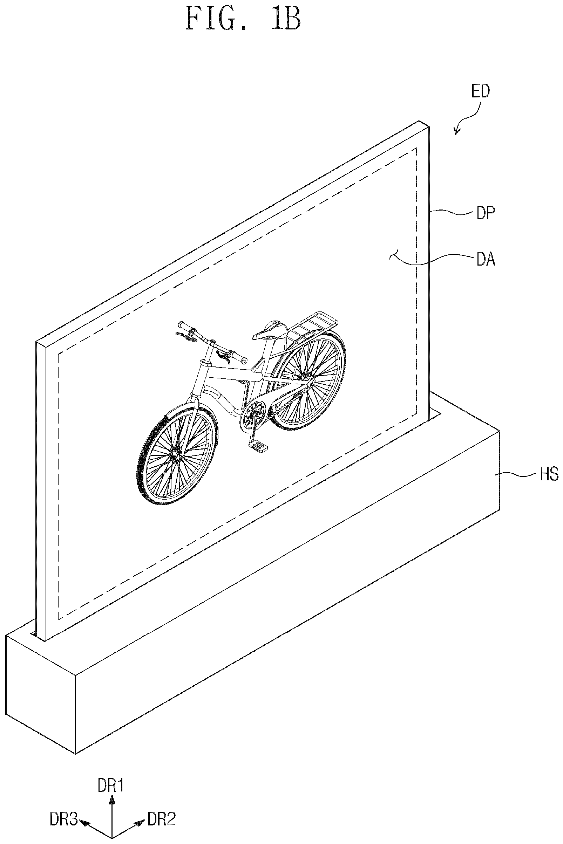

FIG. 1A is a perspective view of an electronic device ED. FIG. 1B is a perspective view of the electronic device ED.

Referring to FIGS. 1A and 1B, the electronic device ED is a device that is activated based on an electrical signal. Electronic devices ED may be used in large-sized electronic devices, such as, for example, televisions or external billboards, as well as small and medium-sized electronic devices, such as, for example, personal computers, laptop computers, personal digital terminals, car navigation units, game consoles, portable electronic devices, and cameras. Furthermore, these are presented as examples, and it is apparent that they may be employed in other electronic devices.

The electronic device ED may include a display panel DP. In an example, the display panel DP may be a small or medium size of several inches or a dozen inches (30cm) or less. Alternatively, the display panel DP may be a large size of tens of inches or more. FIGS. 1A and 1B illustrates the electronic device ED including the display panel DP of several tens of inches or more as an example. The electronic device ED illustrated in FIGS. 1A and 1B may be a television.

The electronic device ED may further include a housing HS. FIGS. 1A and 1B illustrate that the housing HS has a rectangular parallelepiped shape including edges that extend in a first direction DR1, a second direction DR2, and a third direction DR3 as an example. However, the shape of the housing HS is not limited to thereto. The shape of the housing HS may be modified into various shapes supportive of accommodating the display panel DP in the housing HS.

A slot HS-OP is defined in the housing HS. The slot HS-OP is an opening that may be defined on an upper surface of the housing HS, and the display panel DP may be inserted and extracted through the slot HS-OP. The slot HS-OP may be defined on another surface (e.g., a side surface) of the housing HS. FIG. 1A illustrates a first state of the electronic device ED, and FIG. 1B illustrates a second state of the electronic device ED. The first state refers to a state in which the display panel DP is fully received in the housing HS, and the second state refers to a state in which a display area DA of the display panel DP is exposed to an outside of the housing HS.

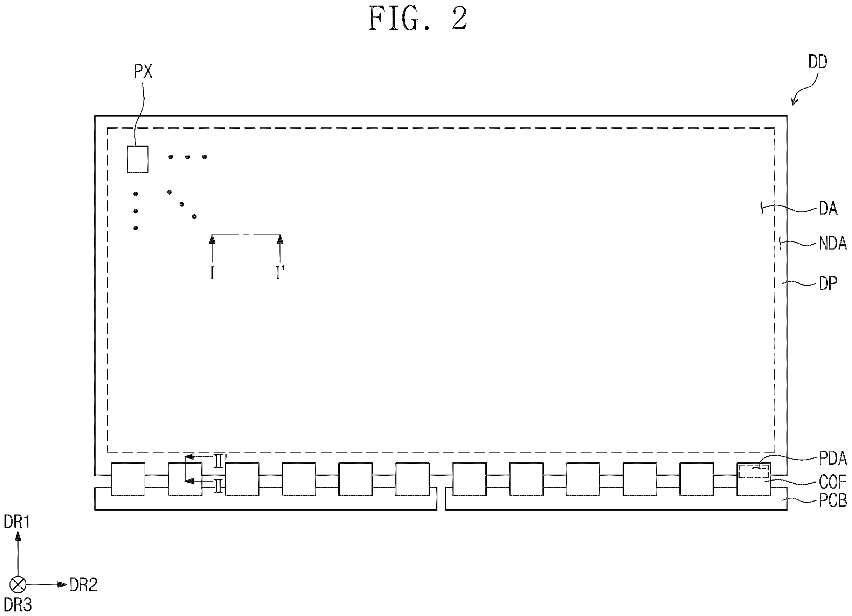

FIG. 2 is a plan view of a display device DD.

Referring to FIGS. 1A, 1B, and 2, the electronic device ED may include the display device DD, and the display device DD may include the display panel DP, a connection film COF, and a circuit substrate PCB.

The display panel DP may be a component that actually generates images. The display panel DP may be a light-emitting display panel, and for example, the display panel DP may be an organic light-emitting display panel, an inorganic light-emitting display panel, an organic-inorganic light-emitting display panel, a quantum dot display panel, a micro LED display panel, or a nano LED display panel.

The display area DA and a non-display area NDA may be defined in the display panel DP. The display panel DP may display images through the display area DA. For example, the display panel DP may include a plurality of pixels PX, and the pixels PX may be disposed in the display area DA. The display area DA may include a surface that is defined by the first direction DR1 and the second direction DR2. The non-display area NDA may surround a periphery of the display area DA.

The display device DD may include a plurality of connection films COF. The display device DD may include a driving circuit (e.g., a data driving circuit) for driving the display panel DP, mounted on each of the connection films COF. The plurality of connection films COF may be coupled to the non-display area NDA of the display panel DP. For example, the connection films COF may be attached to one side of the display panel DP. The connection films COF may be coupled to a pad area PDA of the display panel DP. The pad area PDA may be defined in the non-display area NDA of the display panel DP. The connection films COF and the display panel DP may be coupled to each other by an anisotropic conductive film ACF, but the present disclosure is not particularly limited thereto.

The display device DD may include a plurality of circuit substrates PCB. Each of the circuit substrates PCB may be electrically connected to the display panel DP through a corresponding portion of the connection films COF. A chip (e.g., a timing controller) that controls an operation of the display panel DP may be mounted on the circuit substrate PCB.

FIG. 2 illustrates twelve connection films COF, but the number is not limited thereto. FIG. 2 illustrates two circuit substrates PCB, but the number is not limited thereto. For example, the number of connection films COF and the number of circuit substrates PCB may vary based on a resolution of the display panel DP, a size of the display panel DP, and a specification of the data driving circuit.

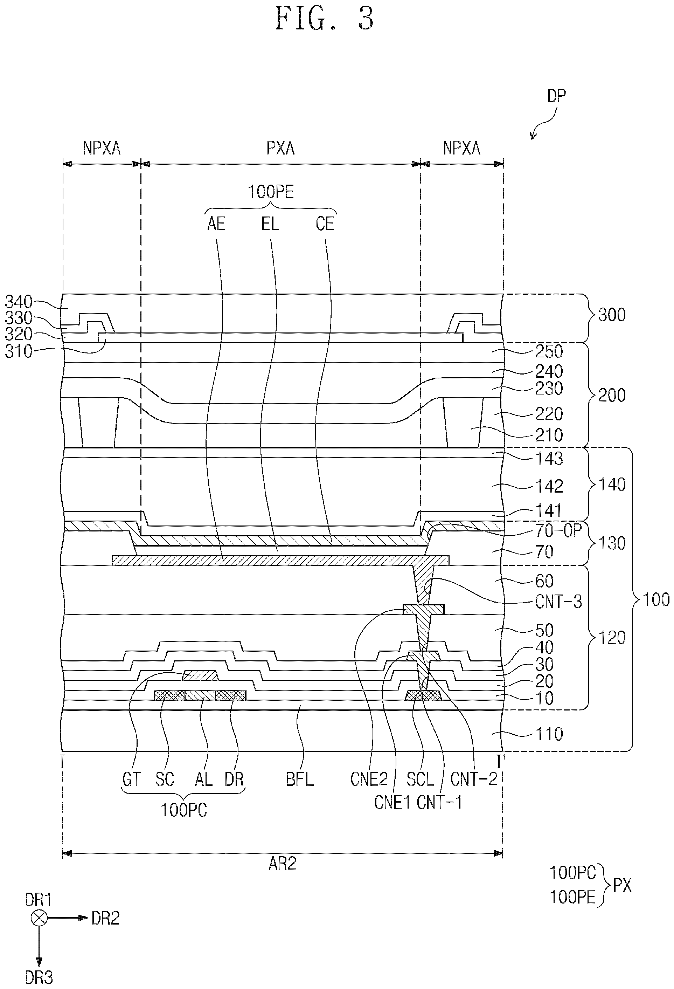

FIG. 3 is a cross-sectional view of the display panel DP. For example, FIG. 3 may be a cross-sectional view taken along line I-I' of FIG. 2.

Referring to FIG. 3, the display panel DP may include a display layer 100, a first optical layer 200, and a second optical layer 300. The first optical layer 200 and the second optical layer 300 may be omitted. The display layer 100 may include a substrate 110, a circuit layer 120, an element layer 130, and an encapsulation layer 140.

The substrate 110 may be a member that provides a base surface on which the circuit layer 120 is disposed. The substrate 110 may be a flexible substrate that may be bent, folded, or rolled. Expressed another way, the substrate 110 may be bendable, foldable, or rollable. The substrate 110 may be a glass substrate. For cases in which the substrate 110 includes glass, the substrate 110 may be bent, folded, or rolled through at least one of thickness control and chemical strengthening processes. For example, the substrate 110 may be formed through at least one of a thickness control process and/or a chemical strengthening processes supportive of bending, folding, or rolling of the substrate 110.

The circuit layer 120 is disposed on the substrate 110. The circuit layer 120 may include an insulating layer, a semiconductor pattern, a conductive pattern, and a signal line. An insulating layer, a semiconductor layer, and a conductive layer are formed on the substrate 110 through coating or deposition, and then the insulating layer, the semiconductor layer, and the conductive layer may be selectively patterned through a plurality of photolithography processes. Thereafter, semiconductor patterns, conductive patterns, and signal lines included in the circuit layer 120 may be formed.

The display panel DP may include a buffer layer BFL. The buffer layer BFL may improve a coupling strength between the substrate 110 and the semiconductor pattern. The buffer layer BFL may include at least one of silicon oxide, silicon nitride, and silicon oxynitride. For example, the buffer layer BFL may include a structure in which silicon oxide layers and silicon nitride layers are alternately laminated.

The semiconductor pattern may be disposed on the buffer layer BFL. The semiconductor pattern may include polysilicon. However, without being limited thereto, the semiconductor pattern may include amorphous silicon, low-temperature polycrystalline silicon, or an oxide semiconductor.

FIG. 3 simply illustrates some semiconductor patterns, and the display panel DP may include semiconductor patterns further disposed in other areas. The semiconductor patterns may be arranged based on a specific rule across pixels. The semiconductor patterns may have different electrical properties based on whether or not the semiconductor patterns are doped. In an example, each semiconductor pattern may include a first area with a high conductivity and a second area with a low conductivity. The first area may be doped with an N-type dopant or a P-type dopant. A P-type transistor may include a doped area doped with a P-type dopant, and an N-type transistor may include a doped area doped with an N-type dopant. The second area may be a non-doped area or an area doped at a lower concentration than the first area.

A conductivity of the first area is greater than a conductivity of the second area, and the first area may substantially function as an electrode or a signal line. The second area may substantially correspond to an active area (or channel) of the transistor. In other words, a portion of the semiconductor pattern may be an active area of the transistor, another portion of the semiconductor pattern may be a source or drain of the transistor, and another portion of the semiconductor pattern may be a connection electrode or a connection signal line.

Each of the pixels PX may include a pixel circuit and a light emitting element 100PE. FIG. 3 illustrates a transistor 100PC included in the pixel circuit as an example. A source area SC, an active area AL, and a drain area DR of the transistor 100PC may be formed from the semiconductor pattern. The source area SC and the drain area DR may extend in opposite directions from the active area AL in a cross-section. FIG. 3 illustrates a portion of a connection signal line SCL formed from the semiconductor pattern. Although not separately illustrated, the connection signal line SCL may be connected to the drain area DR of the transistor 100PC on a plane.

A first insulating layer 10 may be disposed on the buffer layer BFL. The first insulating layer 10 commonly overlaps a plurality of pixels and may cover the semiconductor pattern. The first insulating layer 10 may be an inorganic layer and/or an organic layer, and the first insulating layer 10 may have a single-layer or multi-layer structure. The first insulating layer 10 may include at least one of aluminum oxide, titanium oxide, silicon oxide, silicon nitride, silicon oxynitride, zirconium oxide, and hafnium oxide. The first insulating layer 10 may be a single layer of silicon oxide, but is not limited thereto. The first insulating layer 10 may be an inorganic layer and/or an organic layer, and the first insulating layer 10 may have a single-layer or multi-layer structure. Additionally, or alternatively, the insulating layer of the circuit layer 120 described later may be an inorganic layer and/or an organic layer, and the insulating layer may have a single-layer or multi-layer structure. The inorganic layer may include at least one of the above-mentioned materials, but is not limited thereto.

A gate GT of the transistor 100PC is disposed on the first insulating layer 10. The gate GT may be a portion of a metal pattern. The gate GT overlaps the active area AL. In a process of doping the semiconductor pattern, the gate GT may function as a mask.

A second insulating layer 20 is disposed on the first insulating layer 10 and may cover the gate GT. The second insulating layer 20 may commonly overlap the pixels. The second insulating layer 20 may be an inorganic layer and/or an organic layer, and the second insulating layer 20 may have a single-layer or multi-layer structure. The second insulating layer 20 may include at least one of silicon oxide, silicon nitride, and silicon oxynitride. The second insulating layer 20 may have a multi-layer structure including a silicon oxide layer and a silicon nitride layer.

A third insulating layer 30 may be disposed on the second insulating layer 20. The third insulating layer 30 may have a single-layer or multi-layer structure. For example, the third insulating layer 30 may have a multi-layer structure including a silicon oxide layer and a silicon nitride layer.

A first connection electrode CNE1 may be disposed on the third insulating layer 30. The first connection electrode CNE1 may be connected to the connection signal line SCL through a contact hole CNT-1 that passes through the first, second, and third insulating layers 10, 20, and 30.

A fourth insulating layer 40 may be disposed on the third insulating layer 30. The fourth insulating layer 40 may be a single layer of silicon oxide. The fifth insulating layer 50 may be disposed on the fourth insulating layer 40. The fifth insulating layer 50 may be an organic layer.

A second connection electrode CNE2 may be disposed on the fifth insulating layer 50. The second connection electrode CNE2 may be connected to the first connection electrode CNE1 through a contact hole CNT-2 that passes through the fourth insulating layer 40 and the fifth insulating layer 50.

A sixth insulating layer 60 may be disposed on the fifth insulating layer 50 and may cover the second connection electrode CNE2. The sixth insulating layer 60 may be an organic layer.

The element layer 130 is disposed on the circuit layer 120. The element layer 130 may include the light emitting element 100PE. For example, the element layer 130 may include an organic light emitting material, an inorganic light emitting material, an organic-inorganic light emitting material, quantum dots, quantum rods, a micro LED, or a nano LED. Hereinafter, the light emitting element 100PE will be described as an example of an organic light-emitting element, but the present disclosure is not particularly limited thereto.

The light emitting element 100PE may include a first electrode AE, a light emitting layer EL, and a second electrode CE. The first electrode AE may be disposed on the sixth insulating layer 60. The first electrode AE may be connected to the second connection electrode CNE2 through a contact hole CNT-3 that passes through the sixth insulating layer 60.

A pixel definition film 70 is disposed on the sixth insulating layer 60 and may cover a portion of the first electrode AE. An opening 70-OP is defined in the pixel definition film 70. The opening 70-OP of the pixel definition film 70 exposes at least a portion of the first electrode AE.

The display area DA (see FIG. 2) may include a light emitting area PXA and a non-emission area NPXA that is adjacent to the light emitting area PXA. The non-emission area NPXA may surround the light emitting area PXA. The light emitting area PXA is defined as corresponding to a partial area of the first electrode AE that is exposed through the opening 70-OP.

The light emitting layer EL may be disposed on the first electrode AE. The light emitting layer EL may be disposed in an area corresponding to the opening 70-OP. That is, the light emitting layer EL may be formed such that respective light emitting layers EL are formed in each of the pixels and are separate from one another. In an example in which respective light emitting layers EL are formed in each of the pixels and are separate from each other, each of the light emitting layers EL may emit light of at least one of blue, red, and green. However, they are not limited thereto, and the light emitting layers EL may be connected to the pixels and may be included in as a common light emitting layer EL. In this case, the light emitting layer EL may provide blue light or white light.

The second electrode CE may be disposed on the light emitting layer EL. The second electrode CE has an integral shape, and may be commonly included in a plurality of pixels.

Although not illustrated, a hole control layer may be disposed between the first electrode AE and the light emitting layer EL. The hole control layer may be commonly disposed in the light emitting area PXA and the non-emission area NPXA. The hole control layer may include a hole transport layer and may further include a hole injection layer. An electron control layer may be disposed between the light emitting layer EL and the second electrode CE. The electron control layer includes an electron transport layer, and may further include an electron injection layer. The hole control layer and the electron control layer may be commonly formed in a plurality of pixels by using an open mask or an inkjet process.

The encapsulation layer 140 may be disposed on the element layer 130. The encapsulation layer 140 may protect the element layer 130 from foreign substances, such as, for example, moisture, oxygen, and dust particles. The encapsulation layer 140 may include a first inorganic encapsulation layer 141, an organic encapsulation layer 142, and a second inorganic encapsulation layer 143, which are sequentially laminated, but the arrangement is not limited thereto. The first inorganic encapsulation layers 141 and second inorganic encapsulation layers 143 protect the element layer 130 from moisture and oxygen, and the organic encapsulation layer 142 protects the element layer 130 from foreign substances, such as, for example, dust particles.

The first optical layer 200 may be disposed on the encapsulation layer 140. The first optical layer 200 may include a bank 210, a first filling layer 220, a first cover layer 230, a second cover layer 240, and a third cover layer 250.

The bank 210 may be disposed to overlap the non-emission area NPXA. In FIG. 3, although it is illustrated as an example that the bank 210 has an inverted trapezoidal shape on a cross section, the present disclosure is not particularly limited thereto. For example, the bank 210 may have a trapezoidal shape or a rectangular shape.

The first filling layer 220 may overlap the light emitting area PXA and may be disposed between adjacent banks 210. An upper surface of the first filling layer 220 may have a concave shape. However, the present disclosure is not particularly limited thereto. The shape of the upper surface of the first filling layer 220 may be flat or may have a convex shape.

The first cover layer 230 may be disposed on the banks 210 and the first filling layer 220. The first cover layer 230 may protect the banks 210 and the first filling layer 220. The first cover layer 230 may be provided as a single-layer or a multi-layer. The first cover layer 230 may include an inorganic material. For example, the first cover layer 230 may include at least one of silicon nitride, silicon oxynitride, and silicon oxide.

The second cover layer 240 may be disposed on the first cover layer 230. The second cover layer 240 may be referred to as a low refractive index layer. For example, the second cover layer 240 may be a layer having a lower refractive index than other adjacent layers (e.g., layers adjacent to the second cover layer 240). The second cover layer 240 may provide a flat top surface (also referred to herein as a planar surface).

The third cover layer 250 may be disposed on the second cover layer 240. The third cover layer 250 may protect the second cover layer 240. The third cover layer 250 may be provided as a single-layer or a multi-layer. The third cover layer 250 may include an inorganic material. For example, the third cover layer 250 may include at least any one of silicon nitride, silicon oxynitride, and silicon oxide.

The second optical layer 300 may be disposed on the first optical layer 200. The second optical layer 300 may decrease a reflectance of external light incoming from outside of the display panel DP. Alternatively, the second optical layer 300 may be provided to transmit, among the light provided from the light emitting layer, light of a specific wavelength range.

The second optical layer 300 may include a plurality of color filters 310, 320, and 330, and an overcoating layer 340. One of the color filters 310, 320, and 330 may overlap the light emitting area PXA, and at least two or more of the color filters 310, 320, and 330 may overlap the non-emission area NPXA. A light shielding pattern may be further disposed in the non-emission area NPXA. The overcoating layer 340 may cover the color filters 310, 320, and 330 and may provide a flat upper surface.

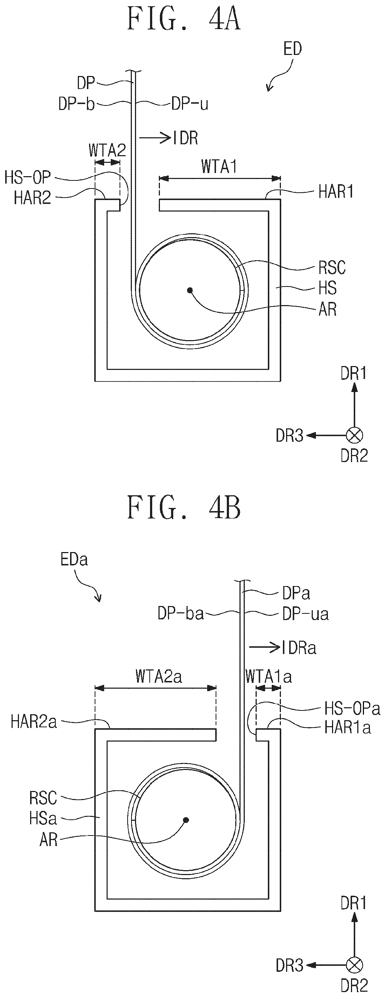

FIG. 4A is a cross-sectional view of the electronic device ED.

Referring to FIG. 4A, the housing HS, the rotation part RSC, and the display panel DP included in the electronic device ED are illustrated as an example.

The rotation part RSC may be disposed in the housing HS. The rotation part RSC may be referred to as a cylinder or circular cylinder. The rotation part RSC may have a structure that is rotatable in the housing HS. For example, the rotation part RSC may be rotated clockwise and counterclockwise about an axis AR that extends in the second direction DR2.

The display panel DP may include a first surface DP-u, on which an image is displayed, and a second surface DP-b that is opposed to the first surface DP-u. The display panel DP may display an image through the first surface DP-u. FIG. 4A illustrates a direction IDR in which the image is displayed.

A portion of the display panel DP may be coupled to the rotation part RSC. For example, a portion of the first surface DP-u of the display panel DP may be coupled to, be attached to, or contact the rotation part RSC. In an example in which the display panel DP is wound on the rotation part RSC, the first surface DP-u, on which the display area of the display panel DP is defined, may be wound to face the rotation part RSC. The example described with reference to FIG. 4A may be referred to as an in-rolling structure.

The location of the slot HS-OP of the housing HS may be biased in one direction. For example, a first width WTA1 of a first area HAR1 from the slot HS-OP to one corner of the housing HS may be larger than a second width WTA2 of a second area HAR2 from the slot HS-OP to the other corner of the housing HS. In this case, an area of the first area HAR1 located in the image display direction IDR may be larger than that of a second area HAR2. However, this is a simple example, and the slot HS-OP of the housing HS may be located at a central portion of the housing HS.

FIG. 4B is a cross-sectional view of an electronic device EDa.

Referring to FIG. 4B, a housing HSa, the rotation part RSC, and a display panel DPa included in the electronic device EDa are illustrated as an example.

The display panel DPa may include a first surface DP-ua, on which an image is displayed, and a second surface DP-ba that is opposed to the first surface DP-ua. The display panel DPa may display an image through the first surface DP-ua. FIG. 4B illustrates a direction IDRa, in which the image is displayed.

A portion of the display panel DPa may be coupled to the rotation part RSC. For example, a portion of the second surface DP-ba of the display panel DPa may be coupled to, be attached to, or contact the rotation part RSC. In an example in which the display panel DPa is wound on the rotation part RSC, the second surface DP-ba, on which the display area of the display panel DPa is not defined, may be wound facing the rotation part RSC. The example described with reference to FIG. 4B may be referred to as an outrolling structure.

The location of a slot HS-OPa of the housing HSa may be biased in one direction. For example, a first width WTA1a of a first area HARIa from the slot HS-OPa to one corner of the housing HSa may be smaller than a second width WTA2a of a second area HAR2a from the slot HS-OPa to another corner of the housing HSa. In this case, an area of the first area HARIa located in the direction IDRa, in which the image is displayed, may be smaller than that of the second area HAR2a. However, this is a simple example, and the slot HS-OPa of the housing HSa may be located at a central portion of the housing HSa.

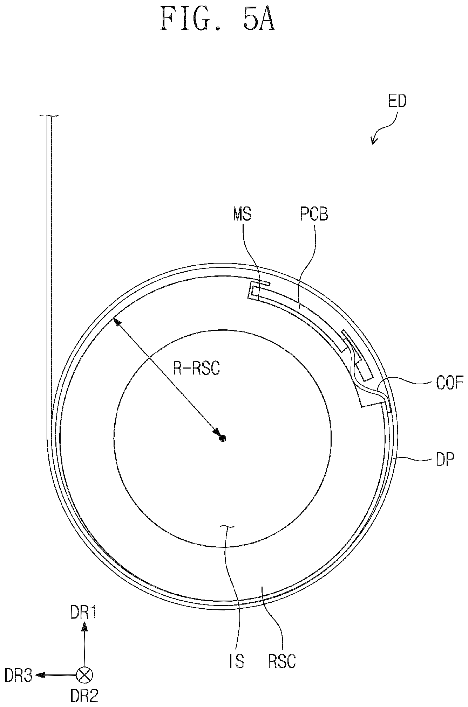

FIG. 5A is a cross-sectional view of the electronic device ED.

Referring to FIG. 5A, the connection film COF that is electrically connected to the display panel DP, and the circuit substrate PCB that is electrically connected to the connection film COF are illustrated. The circuit substrate PCB may be mounted (seated) on the rotation part RSC.

A radius of curvature R-RSC of an outer peripheral surface of the rotation part RSC may be 5 cm, but the present disclosure is not particularly limited thereto. A seating space MS (recessed from an outer peripheral surface, on which the display panel DP is wound) may be defined in the rotation part RSC. The circuit substrate PCB may be disposed in the seating space MS. The seating space MS may also be referred to as a mounting space.

The entire area of the display panel DP may have a structure that is bendable based on a shape of the rotation part RSC. Accordingly, the display panel DP may be bendable, starting from an edge of the display panel DP, which is at least partially covered by the connection film COF.

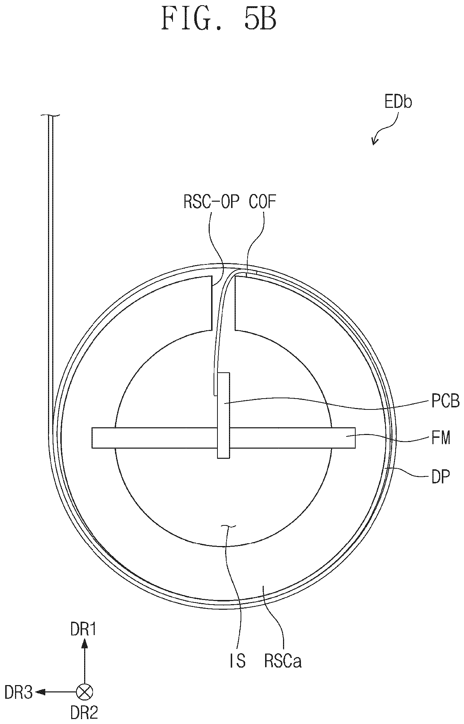

FIG. 5B is a cross-sectional view of an electronic device EDb.

Referring to FIG. 5B, the electronic device EDb may further include a circuit substrate fixing part FM that is disposed in a space IS defined inside a rotation part RSCa. In some aspects, the circuit substrate PCB is fixed to the circuit substrate fixing part FM. The circuit substrate fixing part FM may be fixed to the rotation part RSCa.

The electronic device EDb may include a through part RSC-OP defined in the rotation part RSCa. The through part RSC-OP passes through an outer peripheral surface of the rotation part RSCa from the internal space IS. The connection film COF connected to the circuit substrate PCB and the display panel DP may be disposed to pass through the through part RSC-OP.

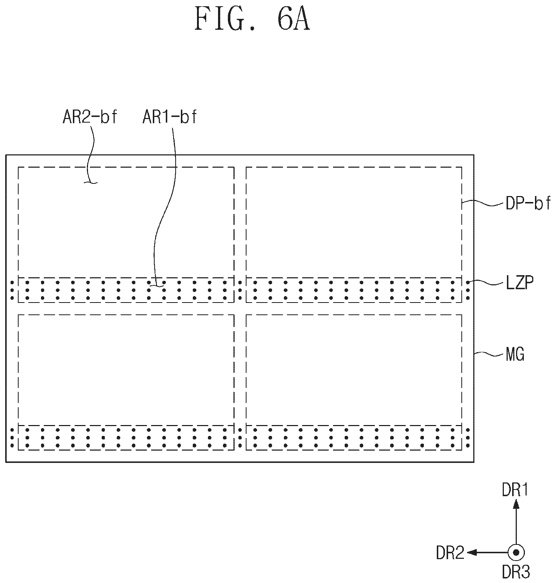

FIGS. 6A to 6C are views illustrating a part of a process of manufacturing a display panel.

Referring to FIGS. 3 and 6A, a mother substrate MG is illustrated. A plurality of preliminary display panels DP-bf may be formed on the mother substrate MG. The mother substrate MG may be a glass substrate. For example, the mother substrate MG may become the substrate 110 through a subsequent process.

The circuit layer 120, the element layer 130, the encapsulation layer 140, the first optical layer 200, and the second optical layer 300 may all be formed on one surface of the mother substrate MG. For example, after a protective layer that covers the circuit layer 120, the element layer 130, the encapsulation layer 140, the first optical layer 200, and the second optical layer 300 is formed, a process of processing the mother substrate MG may be performed, but the present disclosure is not particularly limited thereto.

Referring to FIG. 6A, first portions AR1-bf and second portions AR2-bf may be defined in the mother substrate MG. A laser beam is irradiated to the first portions AR1-bf. A plurality of fine grooves LZP that are arranged along the first direction DR1 and the second direction DR2 may be formed in a first portion AR1-bf by the irradiated laser beam. Each of the fine grooves LZP is obtained by removing a portion of the mother substrate MG in the thickness direction, and does not pass through the mother substrate MG.

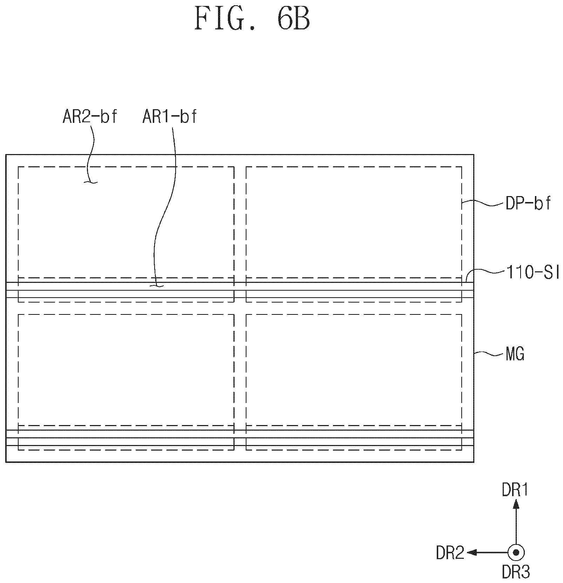

Referring to FIGS. 6A and 6B, the mother substrate MG is etched. In this case, a plurality of slit grooves 110-SI, to which the fine grooves LZP are connected, may be formed. Each of the plurality of slit grooves 110-SI extend along the second direction DR2. The plurality of slit grooves 110-SI may be defined such that the plurality of slit grooves 110-SI are spaced apart in the first direction DR1. The plurality of slit grooves 110-SI may be referred to as a plurality of grooves. Each of the plurality of grooves comprises a slit.

After this (e.g., after the forming of the plurality of slit grooves 110-SI), a chemical strengthening process may be performed which may bring the mother substrate MG containing Na ions in contact with a salt containing K⁺ ions such that Na⁺ and K⁺ ions on the surface are exchanged. However, the chemical strengthening process may be omitted. Furthermore, a process of filling each of the plurality of slit grooves 110-SI with a resin to form a filling member is additionally performed.

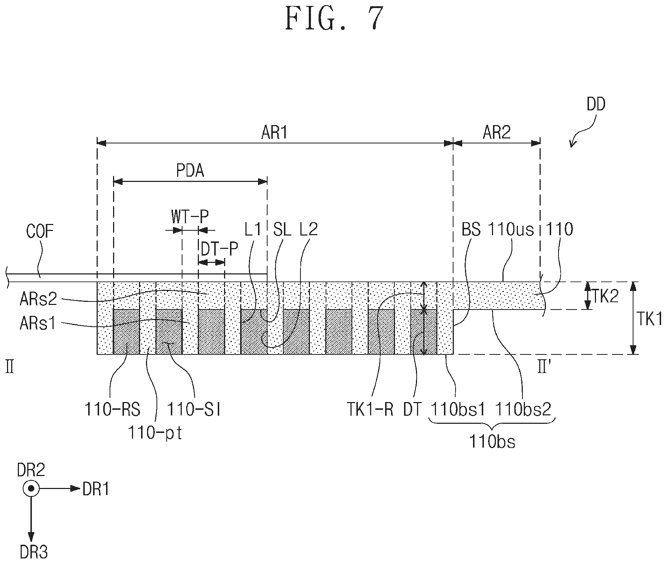

The process of etching a portion of the rear surface of the mother substrate MG may be performed simultaneously with the process of etching the mother substrate MG described with reference to FIG. 6B. For example, referring to FIG. 7 that will be described later, the substrate 110 includes the first portion AR1 and a second portion AR2. A process for reducing the thickness of the second portion AR2 of the substrate 110 may be performed simultaneously with the process of etching the mother substrate MG described with reference to FIG. 6B. However, this is an example, and not limiting. For example, a process of machining the second portion AR2 may be performed after the process of forming the slit grooves 110-SI in the first portion AR1, and additionally, or alternatively, the process of machining the second portion AR2 may be performed before the process of forming the slit grooves 110-SI in the first portion AR1.

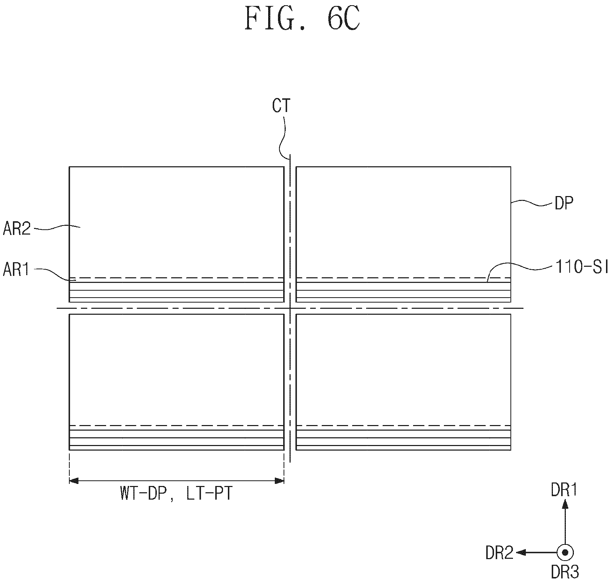

Referring to FIGS. 6B and 6C, the mother substrate MG may be cut (based on a cutting line CT) to form a plurality of display panels DP. The length LT-PT of each of the slit grooves 110-SI in the second direction DR2 may be substantially equal to the width WT-DP of the display panel DP in the second direction DR2. Accordingly, for example, the width of the substrate 110 in the second direction DR2 may be substantially equal to respective lengths LT-PT of the slit grooves 110-SI in the second direction DR2.

The first portion AR1 may be flexible due to the slit grooves 110-SI. The first portion AR1 may have a rigidity supportive of reducing damage to the first portion AR1 by the filling member filled in the slit grooves 110-SI when being attached to the connection film COF (see FIG. 2). That is, in some aspects, the entire area of the display panel DP has a rollable structure, and the area in which the connection film COF is attached is rigid, thereby eliminating or reducing unnecessary dummy areas. Accordingly, a chamfering efficiency of the mother substrate MG may be improved.

FIG. 7 is a cross-sectional view of the display device DD. For example, FIG. 7 may be a cross-sectional view taken along line II-II' of FIG. 2.

Referring to FIG. 7, the substrate 110 may be a glass substrate. The substrate 110 includes the first portion AR1 and the second portion AR2 that is adjacent to the first portion AR1. Referring to FIG. 3, the second portion AR2 of the substrate 110 may overlap the element layer 130. Furthermore, the second portion AR2 of the substrate 110 may overlap the display area DA (see FIG. 1B).

The first portion AR1 has a first thickness TK1, and the second portion AR2 has a second thickness TK2. The second thickness TK2 is smaller than the first thickness TK1, i.e. the second portion AR2 is thinner than the first portion. The first thickness TK1 may correspond to a maximum thickness of the first portion AR1, and the second thickness TK2 may correspond to a minimum thickness or an average thickness of the second portion AR2.

The substrate 110 may include an upper surface 110us and a lower surface 110bs. The upper surface 110us of the substrate 110 may be continuously extended in the first portion AR1 and the second portion AR2 to define the same plane. The upper surface 110us of the substrate 110 may be define a continuous plane across both the first portion AR1 and the second portion AR2. Expressed another way, the upper surface 110us of the substrate 110 may continuously extend across the first portion AR1 and the second portion AR2 to define the same plane. The lower surface 110bs of the substrate 110 may include a first lower surface 110bs1 that overlaps the first portion AR1 and a second lower surface 110bs2 that overlaps the second portion AR2. The first lower surface 110bs1 and the second lower surface 110bs2 may be discontinuous.

A boundary surface BS may be disposed between the first lower surface 110bs1 and the second lower surface 110bs2. The boundary surface BS may be connected to the first lower surface 110bs1 and the second lower surface 110bs2, and the boundary surface BS may be a flat surface. For example, in the illustration of FIG. 7, the boundary surface BS may be a surface that is parallel to the second direction DR2 and the third direction DR3.

Both the first portion AR1 and the second portion AR2 of the substrate 110 may be flexible. Accordingly, the entire area of the display panel DP may be bendable or rollable. A plurality of slit grooves 110-SI that extend along the second direction DR2 that crosses the first direction DR1 may be defined on the first lower surface (also referred to as a bottom surface) 110bs1 of the first portion AR1 of the substrate 110. Each of the plurality of slit grooves 110-SI may have a shape that is recessed in the thickness direction of the substrate 110. For example, each of the plurality of slit grooves 110-SI may have a shape that is recessed from the lower surface 110bs of the substrate 110 toward the upper surface 110us of the substrate 110. The plurality of slit grooves 110-SI may be referred to by various names, such as, for example, concave patterns, recessed patterns, or grooves. In the claims, the slit grooves are referred to as grooves.

Each of the plurality of slit grooves 110-SI may have a substantially rectangular shape on a cross section that is defined by the first direction DR1 and the third direction DR3. For example, a shape of each of the plurality of slit grooves 110-SI may be defined by a first line L1, a straight line SL that is connected to the first line L1, and a second line L2 that is connected to the straight line SL. However, the shape of each of the plurality of slit grooves 110-SI is not limited thereto. For example, each of the plurality of slit grooves 110-SI may have a trapezoidal shape, an inverted trapezoidal shape, or a triangular shape.

The first portion AR1 may include first sub portions ARs1 having the first thickness TK1. The first portion AR1 may include second sub portions ARs2 having a second thickness TK1-R (hereinafter, will be referred to as a third thickness) that is smaller than the first thickness TK1. The first sub portions ARs1 and the second sub portions ARs2 may be repeatedly alternately arranged one by one in the first direction DR1.

A pattern 110-pt may be defined between, among the plurality of slit grooves 110-SI, two adjacent slit grooves 110-SI. The pattern 110-pt may correspond to the first sub portions ARs1. Accordingly, the thickness TK1 of the pattern 110-pt may correspond to the thickness TK1 of the first sub portions ARs1 of the substrate 110.

The second thickness TK2 of the second portion AR2 may be substantially equal to the third thickness TK1-R of the second sub portions ARs2. Accordingly, the depth DT of each of the plurality of slit grooves 110-SI is substantially equal to the difference between the first thickness TK1 of the first portion AR1 and the second thickness TK2 of the second portion AR2.

The first thickness TK1 of the first portion AR1 may be five times or greater than the second thickness TK2 of the second portion AR2, but is not particularly limited thereto. For example, the first thickness TK1 of the first portion AR1 may be 500 micrometers, the second thickness TK2 of the second portion AR2 may be 100 micrometers, and the depth DT of each of the plurality of slit grooves 110-SI may be 400 micrometers. However, this is a simple example, and the first thickness TK1, the second thickness TK2, and the depth DT are not limited to the example values provided herein.

The width DT-P of each of the plurality of slit grooves 110-SI and a spacing WT-P between the plurality of slit grooves 110-SI are determined based on target curvature values. For example, the width DT-P of each of the plurality of slit grooves 110-SI may be 80 micrometers to 150 micrometers, and the spacing WT-P between the plurality of slit grooves 110-SI may range from 150 micrometers to 170 micrometers. The width DT-P of each of the plurality of slit grooves 110-SI may correspond to a spacing between the first sub portions ARs1 or a spacing between the patterns 110-pt. The spacing WT-P between the plurality of slit grooves 110-SI may correspond to a width of each of the first sub portions ARs1 or a width of each of the patterns 110-pt.

The display device DD may further include a plurality of filling members 110-RS, which are disposed in the plurality of slit grooves 110-SI, respectively. Each of the plurality of filling members 110-RS may include a resin. Each of the plurality of filling members 110-RS may be aligned with the lower surface 110bs of the substrate 110, particularly, the first lower surface 110bs1. For example, one filling member 110-RS may be disposed between two adjacent first sub portions ARs1 of the plurality of first sub portions ARs1.

The first portion AR1 may be easily bent by the plurality of slit grooves 110-SI, and the relatively thin second portion AR2 may also be easily bent. That is, an entire area of the display panel DP may have a bendable/rollable structure. Furthermore, the pad area PDA, to which the connection film COF is attached, may be defined in the first portion AR1. The first thickness TK1 of the first portion AR1 is larger than the second thickness TK2 of the second portion AR2. Furthermore, the filling members 110-RS are disposed in the plurality of slit grooves 110-SI corresponding to the relatively thin portions. By the slit grooves 110-SI filled with the filling members 110-RS, the substrate 110 may have a rigidity which may prevent breaking of or damage to the substrate 110 when the connection film COF (see FIG. 2) is attached. Accordingly, during a process of bonding the connection film COF to the pad area PDA, a possibility of a crack occurring in the first portion AR1 may be reduced or eliminated.

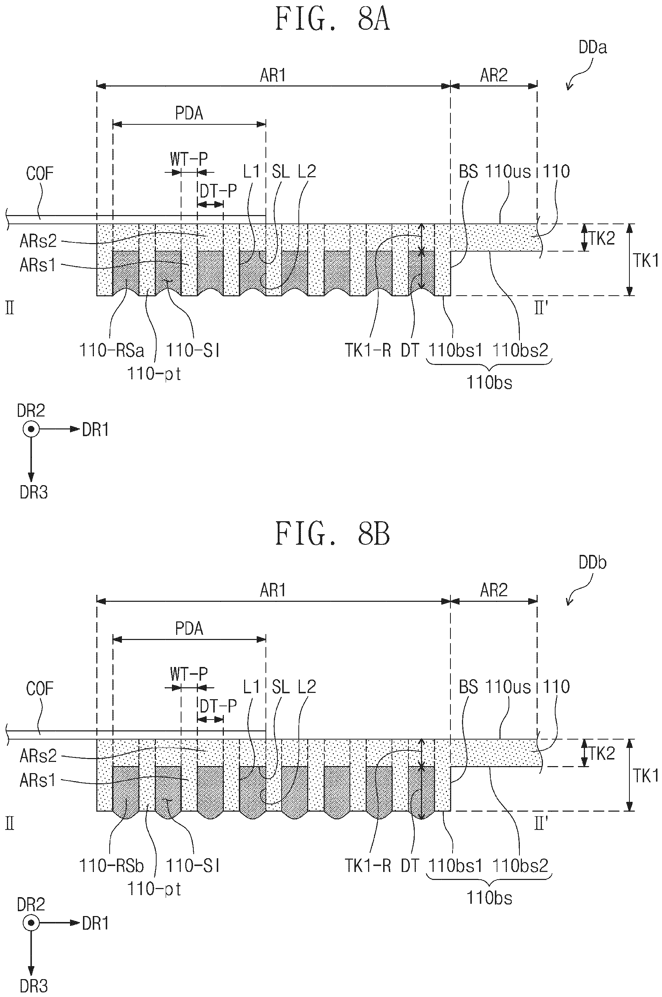

FIG. 8A is a cross-sectional view of a display device DDa. In describing FIG. 8A, the components that are the same as those described in FIG. 7 are denoted by the same reference numerals, and repeated descriptions of the components are omitted for brevity.

Referring to FIG. 8A, the display device DDa may further include a plurality of filling members 110-RSa that are disposed in the plurality of slit grooves 110-SI, respectively. Each of the plurality of filling members 110-RSa may include a resin. Each of the plurality of filling members 110-RSa may have a concave shape with respect to the lower surface 110bs of the substrate 110, particularly, the first lower surface 110bs1.

FIG. 8B is a cross-sectional view of a display device DDb. In describing FIG. 8B, the components that are the same as those described in FIG. 7 are denoted by the same reference numerals, and repeated descriptions of the components are omitted for brevity.

Referring to FIG. 8B, the display device DDb may further include a plurality of filling members 110-RSb that are disposed in the plurality of slit grooves 110-SI. The plurality of filling members 110-RSb may include a resin. Each of the plurality of filling members 110-RSb may have a shape that protrudes convexly with respect to the lower surface 110bs of the substrate 110, particularly the first lower surface 110bs1.

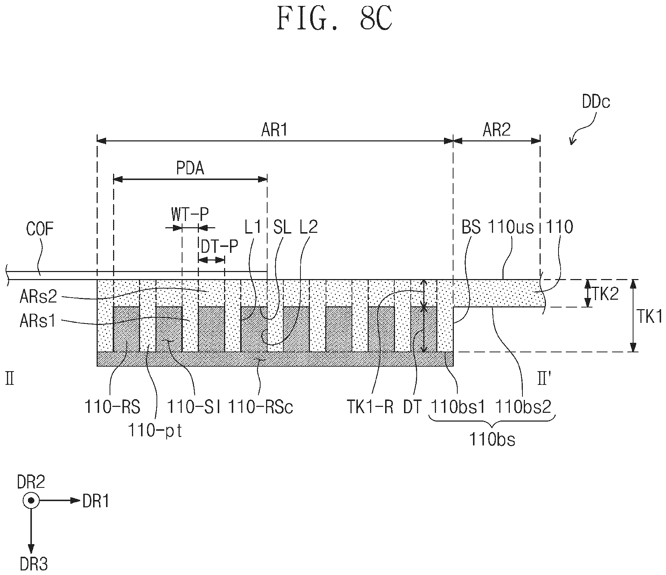

FIG. 8C is a cross-sectional view of a display device DDc. In a description of FIG. 8C, the components that are the same as those described in FIG. 7 are denoted by the same reference numerals and repeated descriptions of the components are omitted for brevity.

Referring to FIG. 8C, the display device DDc may further include the plurality of filling members 110-RS that are disposed in the plurality of slit grooves 110-SI, respectively, and a cover layer 110-RSc that are integrally provided with the plurality of filling members 110-RS and covers the lower surface 110bs of the substrate 110, in particular, the first lower surface 110bs1.

Because the cover layer 110-RSc is additionally provided, the first thickness TK1 of the first portion AR1 as described with reference to FIG. 8C may be less than the first thickness TK1 of the first portion AR1 previously described with reference to FIGS. 7, 8A, and 8B. However, the present disclosure is not particularly limited thereto.

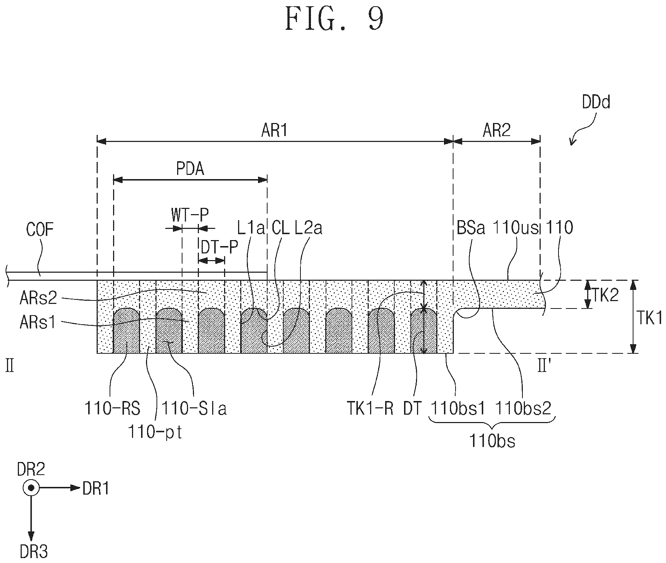

FIG. 9 is a cross-sectional view of a display device DDd. In a description of FIG. 9, the components that are the same as those described in FIG. 7 are denoted by the same reference numerals and repeated descriptions of the components are omitted for brevity.

Referring to FIG. 9, the substrate 110 may include the first portion AR1 and the second portion AR2 that is adjacent to the first portion AR1. The substrate 110 may include the upper surface 110us and the lower surface 110bs. The upper surface 110us of the substrate 110 may continuously extend in the first portion AR1 and the second portion AR2 to define the same plane. Expressed another way, the upper surface 110us of the substrate 110 may continuously extend across the first portion AR1 and the second portion AR2 to define the same plane. The lower surface 110bs of the substrate 110 may include the first lower surface 110bs1 that overlaps the first portion AR1 and the second lower surface 110bs2 that overlaps the second portion AR2. The first lower surface 110bs1 and the second lower surface 110bs2 may be discontinuous.

A boundary surface BSa may be disposed between the first lower surface 110bs1 and the second lower surface 110bs2. The boundary surface BSa may be connected to the first lower surface 110bs1 and the second lower surface 110bs2, and the boundary surface BSa may include a curved surface. For example, each of the first lower surface 110bs1 and the second lower surface 110bs2 may be a surface that is parallel to the first direction DR1 and the second direction DR2, and the boundary surface BSa may connect (e.g., gently connect) the first lower surface 110bs1 and the second lower surface 110bs2.

Both the first portion AR1 and the second portion AR2 of the substrate 110 may be flexible. Accordingly, the entire area of the display panel DP may be bendable or rollable. A plurality of slit grooves 110-Sla that extend along the second direction DR2 that crosses the first direction DR1 are defined on the first lower surface 110bs1 of the first portion AR1 of the substrate 110. Each of the plurality of slit grooves 110-Sla may have a shape that is recessed in the thickness direction of the substrate 110.

On a cross section defined in the first direction DR1 and the third direction DR3, the shape of each of the plurality of slit grooves 110-Sla may be defined by a first line L1a, a curved line CL that is connected to the first line L1a, and a second line L2a is connected to the curve CL. Each of the plurality of slit grooves 110-Sla may have a curved top portion in cross-section. However, the shape of each of the plurality of slit grooves 110-Sla is not limited thereto.

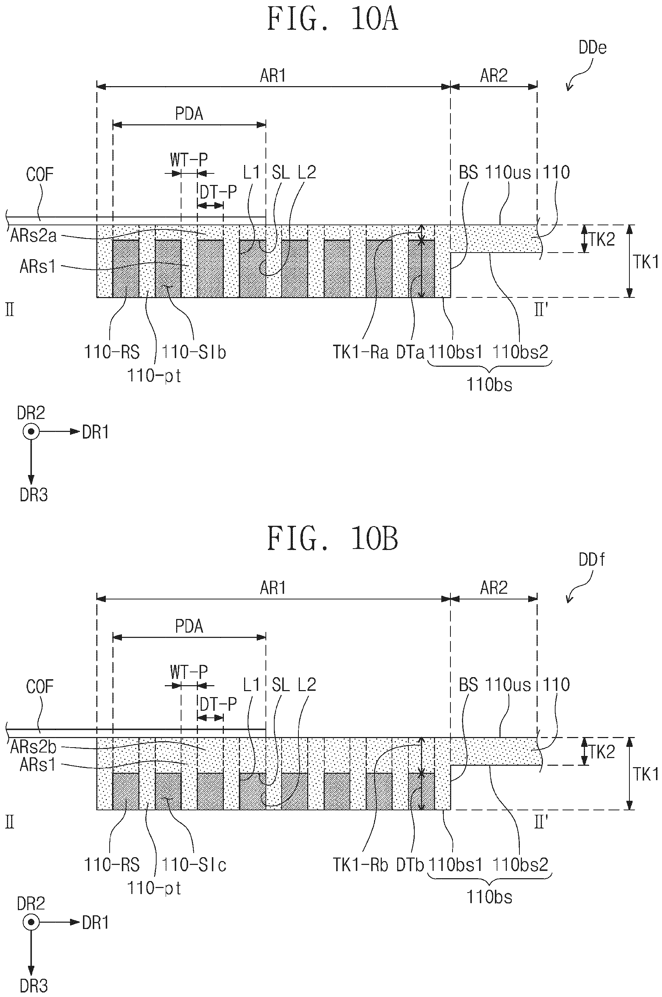

FIG. 10A is a cross-sectional view of a display device DDe. In a description of FIG. 10A, the components that are the same as those described in FIG. 7 are denoted by the same reference numerals, and repeated descriptions of the components are omitted for brevity.

Referring to FIG. 10A, a plurality of slit grooves 110-Slb may be defined on the first lower surface 110bs1 of the first portion AR1 of the substrate 110. Each of the plurality of slit grooves 110-Slb may have shape that is recessed in the thickness direction of the substrate 110.

The first portion AR1 includes the first sub portions ARs1 having the first thickness TK1 and second sub portions ARs2a having a second thickness TK1-Ra (hereinafter, referred to as the third thickness) that is smaller than the first thickness TK1. The first sub portions ARs1 and second sub portions ARs2a may be repeatedly alternately arranged one by one along the first direction DR1.

The second thickness TK2 of the second portion AR2 may be greater than the third thickness TK1-Ra of the second sub portions ARs2a. A depth DTa of each of the plurality of slit grooves 110-Slb may be greater than the difference between the first thickness TK1 of the first portion AR1 and the second thickness TK2 of the second portion AR2.

FIG. 10B is a cross-sectional view of a display device DDf. In a description of FIG. 10B, the components that are the same as those described in FIG. 7 are denoted by the same reference numerals, and repeated descriptions of the components are omitted for brevity.

Referring to FIG. 10B, a plurality of slit grooves 110-Slc may be defined on the first lower surface 110bs1 of the first portion AR1 of the substrate 110. Each of the plurality of slit grooves 110-Slc may have a shape that is recessed in the thickness direction of the substrate 110.

The first portion AR1 may include the first sub portions ARs1 having the first thickness TK1 and second sub portions ARs2b having a second thickness TK1-Rb (hereinafter, referred to as a third thickness) that is smaller than the first thickness TK1. The first sub portions ARs1 and the second sub portions ARs2b may be repeatedly alternately arranged one by one along the first direction DR1.

The second thickness TK2 of the second portion AR2 may be smaller than the second thickness TK1-Rb of the second sub portions ARs2b. The depth DTb of each of the plurality of slit grooves 110-Slc may be smaller than the difference between the first thickness TK1 of the first portion AR1 and the second thickness TK2 of the second portion AR2.

Features of the embodiments previously described with reference to FIGS. 7 to 10B may be combined with each other. Accordingly, implementations are not limited to the embodiments illustrated in FIGS. 7 to 10B.

According to the above description, the substrate of the display panel includes the first portion and the second portion having different thicknesses. The first portion having a relatively large thickness is provided with the plurality of slit grooves, and the filling members are disposed in the slit grooves. The first portion also may be bendable due to the slit grooves, and the entire area of the display panel may be rollable. In some aspects, the substrate has a rigidity, by which the substrate is not damaged when the connection film is attached, by the filling members filled in the slit grooves.

According to an aspect of the invention, a substrate of a display panel comprises adjacent first and second portions, wherein the second portion is thinner than the first portion, wherein the first portion comprises a plurality of grooves extending from the bottom surface of the first portion towards the top of the first portion.

The above has been described with reference to example embodiments, but those skilled in the art or having ordinary knowledge in the field will understand that the present disclosure may be variously changed while not deviating from the scope of the invention as defined by the claims.

## Claims

1. A display panel comprising:
a substrate (110) comprising:
a first portion (AR1) having a first thickness (TK1), and
a second portion (AR2) adjacent to the first portion (AR1) in a first direction (DR1), the second portion (AR2) having a second thickness (TK2) which is smaller than the first thickness (TK1);
a circuit layer (120) disposed on the substrate; and
an element layer (130) disposed on the circuit layer,
wherein the bottom surface (110bs1) of the first portion (AR1) comprises a plurality of grooves (110-SL, 110-Sla, 110-SLb, 110-SLc) extending along a second direction (DR2) crossing the first direction (DR1).

2. The display panel of claim 1, wherein the width of the substrate in the second direction is substantially equal to the length of each of the plurality of grooves in the second direction.

3. The display panel of claim 1 or 2, wherein the depth of each of the plurality of grooves is substantially equal to the difference between the first thickness and the second thickness.

4. The display panel of claim 1 or 2, wherein the depth of each of the plurality of grooves is greater than the difference between the first thickness and the second thickness.

5. The display panel of claim 1 or 2, wherein the depth of each of the plurality of grooves is smaller than the difference between the first thickness and the second thickness.

6. The display panel of any one of the preceding claims, wherein the first thickness (TK1) is at least five times the second thickness (TK2).

7. The display panel of any one of the preceding claims, wherein the upper surface of the substrate defines a continuous plane across both the first portion and the second portion.

8. The display panel of claim 7, wherein a boundary surface (BS) connecting the bottom surface (110bs1) of the first portion and the bottom surface (110bs2) of the second portion is a flat surface and/or a curved surface.

9. The display panel of any one of the preceding claims, further comprising:
a plurality of filling members (110-RS, 110-RSa, 110-RSb) disposed in the plurality of grooves, respectively.

10. The display panel of claim 10, wherein each of the plurality of filling members is aligned with the bottom surface (110bs1) of the first portion (AR1) or has a shape that is recessed concavely from the bottom surface of the first portion or has a shape that protrudes convexly from the bottom surface of the first portion.

11. The display panel of claim 9 or 10, further comprising:
a cover layer (110-RSc) provided integrally with the plurality of filling members, and covering the bottom surface of the first portion (AR1).

12. The display panel of any one of the preceding claims, wherein each of the plurality of grooves comprises a slit.

13. The display panel of any one of the preceding claims, wherein each of the plurality of grooves has a substantially rectangular cross-section.

14. The display panel of any one of claims 1 to 11, wherein each of the plurality of grooves has a curved top portion in cross-section.

15. The display panel of any one of the preceding claims, wherein the substrate is a glass substrate, and the first portion and the second portion of the substrate are flexible.
